# FASCICULE DE BREVET EUROPEEN

(11) **EP 0 443 958 B1**
(45) Date de publication et mention de la délivrance du brevet: **01.05.1996**
(21) Numéro de dépôt: 91400478.3
(22) Date de dépôt: 21.02.1991
(51) Int. Cl.: H01L 21/82, H01L 21/768, G11C 11/401

(54) **Procédé de fabrication d'un circuit intégré pour filière analogique rapide utilisant des lignes d'interconnexions locales en siliciure**
Verfahren zum Herstellen einer analogen integrierten Hochgeschwindigkeitsschaltung unter Verwendung von lokalen Leitungsverbindungen aus Silizid
Method of manufacturing a high speed analog integrated circuit using silicide local interconnections

(30) Priorité: 23.02.1990 FR 9002272
(43) Date de publication de la demande: 28.08.1991
(73) Titulaire: FRANCE TELECOM, F-92131 Issy les Moulineaux (FR)
(72) Inventeur: Bonis, Maurice, F-38190 Brignoud (FR)
(74) Mandataire: Signore, Robert

(56) Documents cités:
- EP-A- 0 200 364
- EP-A- 0 321 860
- US-A- 4 519 126
- IEEE 1989 CUSTOM INTEGRATED CIRCUITS CONFERENCE 1989, pages 1851 - 1854; R.W.
- GREGOR ET.AL.: "A SUBMICRON ANALOG CMOS TECHNOLOGY"

## Description

La présente invention a pour objet un procédé de fabrication d'un circuit intégré comportant des transistors MIS à double jonction, des condensateurs reliés électriquement à ces transistors et éventuellement des résistances haute valeur pour une filière mixte digitale-analogique rapide submicronique, utilisant des lignes d'interconnexions locales en siliciure. Elle s'applique en particulier dans le domaine des circuits du type nMOS, pMOS et CMOS de haute densité et de grande rapidité utilisés pour le traitement des signaux logiques et analogiques et dans le domaine des circuits mémoire.

Plus spécialement, l'invention se rapporte à la fabrication d'un circuit comportant des transistors MIS et des condensateurs en particulier pour des circuits amplificateurs, des circuits de filtrage à capacités commutées, des circuits convertisseurs numérique/analogique ou analogique/numérique, des mémoires dynamiques DRAM. Dans ce type de circuits, les condensateurs sont situés sur des zones d'isolation électrique ou oxyde de champ du circuit intégré.

Dans une filière analogique connue, les condensateurs sont formés par une première couche de silicium polycristallin dopé noté poly-1, une oxydation thermique de cette couche de silicium ou un depôt d'oxyde CVD et une seconde couche de silicium polycristallin déposé sur l'oxyde thermique et noté poly-2. Dans la première couche de silicium polycristallin, est formée en outre la grille des transistors du circuit intégré. Un exemple de circuits analogiques connus de ce type est décrit dans le document FR-A-2 601 817 déposé au nom du demandeur.

Par ailleurs, dans le document IEEE 1989 - Custom Integrated Circuits Conference "A Submicron Analog, CMOS Technology " R.W. Gregor et al. 18.5.1 - 18.5.4, il est enseigné la réalisation de résistances haute valeur dans le poly-1.

Le poly-2 tel qu'il est utilisé pour la réalisation des condensateurs introduit un niveau de plus dans la structure des circuits intégrés augmentant ainsi sensiblement le relief de ces circuits, ce qui rend plus difficiles les étapes de nivellement (connues sous le terme de planarisation) par les matériaux diélectriques utilisés entre les différentes couches conductrices. Ceci rend en outre difficile la réduction des dimensions des circuits intégrés. En effet, le plus petit motif de ces circuits, constitué généralement par la grille des transistors, est de 1 micromètre.

Par ailleurs, la gravure du poly-2 est délicate, car il se forme des résidus de gravure au pied du poly-1 du fait de la marche abrupte constituée par les grilles des transistors situées entre les zones d'isolation latérale électrique. Pour éviter ces résidus, on doit utiliser une gravure chimique isotrope entraînant ainsi une perte de cote importante sur le poly-2.

Pour réduire cette perte de cote, on choisit en général une épaisseur de poly-2 faible entraînant ainsi la réalisation de résistances électriques de forte valeur pour les armatures supérieures des condensateurs, limitant la vitesse de fonctionnement de ces circuits.

Dans un procédé modifié, on peut réaliser le poly-1 des condensateurs avant celui des grilles, celles-ci étant alors réalisées dans le poly-2. Dans ce cas, la difficulté de gravure est reportée sur la gravure des grilles, les résidus de gravure se formant au pied du poly-1 des condensateurs. Or, la gravure des grilles est une opération très critique pour la réalisation d'une filière analogique submicronique.

Dans les filières logiques (ou digitales) connues, on forme sur la grille des transistors et sur leur zone de drain et source une couche de siliciure d'un métal réfractaire, de faible résistivité, par réaction du silicium et d'un métal réfractaire. Cette technique est connue sous le nom de technique salicide (self aligned silicide en terminologie anglo-saxonne) et est en particulier décrite dans le document IEEE Journal of Solid-State Circuits, vol. SC-20, n°1 Fevrier 1985 "Development of the self-aligned titanium silicide process for VLSI applications", M.E. Alperin et al., pp. 61-69.

Cette technique présente un certain nombre d'avantages, tels que la réduction de la résistance de la grille ainsi que des interconnexions de ces grilles en silicium polycristallin (de 25 ohms à 3 ohms/carré) améliorant ainsi la vitesse de fonctionnement des circuits intégrés. Elle permet en outre une réduction de la résistance des zones de source et drain grâce à la réalisation de shunts en siliciure permettant alors de réduire le nombre de contacts électriques sur ces zones actives entraînant un gain en densité d'intégration.

Cette couche de siliciure n'assure que des connexions soit entre grilles, soit entre drains, soit entre sources, mais ne permet pas la réalisation d'interconnexions entre des sources et des drains ou entre des grilles et des zones actives (source ou drain). Ces interconnexions sont en effet réalisées, après dépôt d'une couche d'isolant sur l'ensemble du circuit puis ouverture de trous de contact dans cet isolant, dans une couche métallique gravée selon les motifs voulus ; elles constituent le premier niveau d'interconnexions.

Cette technologie salicide est incompatible avec les filières analogiques connues, car on ne sait pas oxyder correctement un siliciure de façon à former des condensateurs siliciure/oxyde/poly. Par ailleurs, si on formait le siliciure après la gravure du poly-2, les condensateurs seraient court-circuités par le siliciure.

Par ailleurs, on connaît la technique de fabrication de lignes d'interconnexions locales (LIL) qui est une extension de la technique salicide décrite ci-dessus. Cette technologie est notamment décrite dans le document J. Vac. Sci. Technol. B6(6), nov./dec. 1988 "TiSi₂ strap formation by Ti-amorphous-Si reaction" de H.J.W Van Houtum et al., pp. 1734-1739.

Elle consiste à former des interconnexions en siliciure à la fois sur les drains et les sources des transistors à connecter et sur l'isolant épais (LOCOS en général). Ceci permet d'assurer des liaisons à courte distance entre les transistors, sans aucune interface entre les différentes couches et surtout de pouvoir reporter les contacts électriques sur l'isolant. On peut alors réduire la surface des sources et des drains et donc augmenter la densité d'intégration des circuits.

Par ailleurs, cette technique présente un important avantage qui est que l'ouverture des trous de contact électrique dans l'isolant recouvrant les transistors et les condensateurs est beaucoup plus facile. En effet, les trous de contact sont gravés dans un isolant épais beaucoup plus uniforme que celui utilisé dans la filière analogique facilitant ainsi le nivellement des circuits.

Comme précédemment, cette technologie est incompatible avec les filières analogiques connues.

L'invention a justement pour objet un procédé de fabrication d'un circuit intégré pour filière mixte analogique-logique comportant des transistors MIS et des condensateurs et éventuellement des résistances de haute valeur (400 ohms à 2 kohms/carré) permettant de remédier aux inconvénients ci-dessus.

L'objectif principal de l'invention est de réaliser des condensateurs dans une filière analogique, de façon entièrement compatible avec la siliciuration des grilles et des zones de source et drain des transistors de façon à conserver à la partie logique du circuit, la densité maximum d'intégration et la vitesse maximum de fonctionnement.

De façon plus précise, l'invention a pour objet un procédé de fabrication d'un circuit intégré analogique-logique sur un substrat en silicium incluant une première et une seconde régions adjacentes et comportant, dans la première région, une isolation électrique supportant un condensateur et, dans la seconde région, un transistor MIS à double jonction dont l'une des zones actives est reliée électriquement à une première armature du condensateur par une ligne d'interconnexion, ce procédé consistant à réaliser, simultanément, en un siliciure d'un métal réfractaire i) ladite ligne d'interconnexion directement sur la zone active et sur la première armature à connecter, ii) la seconde armature du condensateur et iii) les shunts respectivement de la grille, de la source et du drain du transistor.

Selon l'invention, par circuit analogique-logique, il faut comprendre un circuit intégré mixte comportant des parties logiques et des parties analogiques, les condensateurs étant partie intégrante des parties analogiques.

Ce procédé présente un certain nombre d'avantages par rapport à l'art antérieur. En particulier, la qualité des condensateurs est excellente et la résistance de l'armature supérieure ou seconde armature est très faible (3 ohms/carré au lieu de 40 à 50 ohms/carré dans la technologie analogique classique), augmentant ainsi la rapidité des circuits.

Par ailleurs, ces condensateurs sont connectés directement aux régions de source et drain ou aux grilles des transistors, par le prolongement de leur armature, sans aucune interface avec des lignes d'interconnexions métalliques. De plus, ces condensateurs ne créent aucun relief supplémentaire par rapport aux grilles des transistors ou plus exactement de leur shunt en siliciure.

Le procédé de l'invention bénéficie évidemment de tous les avantages de la technologie des lignes d'interconnexions locales (LIL) et en particulier une plus grande densité d'intégration par réduction des surfaces des sources et des drains. En effet, ce procédé permet de supprimer les prises de contact électrique sur les zones actives (sources ou drains). Cette technologie permet en outre et surtout une plus grande facilité de gravure des trous de contact lorsqu'on utilise un diélectrique de nivellement. Or, dans les filières submicroniques, l'utilisation de ce diélectrique est pratiquement indispensable en raison de la réduction des dimensions des motifs.

Selon l'invention, on peut utiliser un grand nombre de métaux réfractaires pour constituer le siliciure, comme par exemple le tungstène, le titane, le tantale, le molybdène, le zirconium. De préférence, on utilise le titane.

La couche de siliciure du type MSi₂ (avec M un métal refractaire) peut être formée par dépôt d'une couche d'un métal réfractaire sur l'ensemble du circuit intégré, suivi d'un dépôt sur cette couche de métal de silicium amorphe que l'on grave pour y former le motif de la ligne d'interconnexion à réaliser entre le transistor et le condensateur ainsi que le motif de la seconde armature de ce condensateur.

On fait alors réagir thermiquement, sous atmosphère d'azote, le métal réfractaire avec, d'une part, le silicium amorphe déposé et, d'autre part, le silicium monocristallin du substrat sous-jacent dans les zones de source et drain et éventuellement le silicium polycristallin de la grille, lorsque cette dernière est fabriquée dans ce matériau, pour former le siliciure puis on élimine le métal réfractaire n'ayant pas réagi. Dans cette solution, l'épaisseur du siliciure formé est deux fois plus forte sur les zones couvertes par le silicium amorphe (ligne d'interconnexion et seconde armature du condensateur).

Pour éviter cette surépaisseur, on réalise de préférence la couche de siliciure :
a) - en déposant sur l'ensemble du circuit une couche de silicium polycristallin,
b) - en gravant cette couche de silicium pour y former les motifs respectivement de la ligne d'interconnexion et de la première armature du condensateur,
c) - en déposant une première couche de métal réfractaire sur la structure obtenue en b),
d) - en faisant réagir thermiquement le métal avec le silicium sous-jacent pour former un siliciure à l'emplacement desdits motifs de ce métal, et
e) - en éliminant le métal réfractaire n'ayant pas réagi avec le silicium.

De même, pour des raisons de surépaisseur, la première armature du condensateur et la grille du transistor sont réalisées dans une même couche conductrice, en silicium polycristallin dopé. Toutefois, il est éventuellement possible de les réaliser en métal tel que Al, W, Ti, Mo. Dans ce cas, on grave la couche de silicium polycristallin destiné à former la ligne d'interconnexion entre le transistor et le condensateur de façon à y former, de plus, le motif du shunt de la grille du transistor.

Dans cette mise en oeuvre, la réaction du métal avec le silicium sous-jacent pour former le siliciure se fait de façon uniforme sur toutes les zones de la plaquette du circuit intégré. En outre, lorsque le recuit se fait sous azote, il se forme du TiN de façon uniforme sur toute la plaquette du circuit intégré évitant l'extension latérale du siliciure sur l'isolation électrique (isolant de champ) et donc des courts-circuits éventuels entre les zones actives (sources ou drains) et la grille du transistor.

La couche de siliciure MSi₂ peut être formée également par dépôt sélectif de siliciure sur les régions du circuit où du silicium est à nu. Cette méthode est décrite dans le document Appl. Phys. Lett. 55(15), 9 Octobre 1989 "Kinetics aspects of TiSi₂ deposition without silicon consumption" de D. Bensahel et J.L. Regolini et J. Mercier. Cette technique présente l'avantage de consommer très peu de silicium sur la plaquette. L'épaisseur de silicium polycristallin pour les LIL peut donc être très faible (300-400 A°), ce qui facilite encore la gravure du poly 2.

Le procédé de l'invention permet en outre la réalisation de résistance de forte valeur permettant un gain en densité d'intégration supplémentaire par rapport à la technologie analogique classique où elle se trouvait réalisée dans le poly-1.

Le procédé de l'invention s'applique en outre avantageusement à des filières mixtes analogiques-logiques de 0,7 à 0,5 micromètre de largeur de motif élémentaire.

D'autres caractéristiques et avantages de l'invention ressortiront mieux de la description qui va suivre, donnée à titre illustratif et non limitatif, en référence aux dessins annexés dans lesquels :
- les figures 1 à 12 et 14 à 16 représentent schématiquement, en coupe longitudinale, les différentes étapes du procédé conforme à l'invention,
- la figure 13 représente schématiquement une variante du procédé conforme à l'invention,
- les figures 17 à 19 représentent schématiquement une autre variante du procédé de l'invention pour la fabrication d'une résistance haute valeur, et
- les figures 20 à 22 représentent schématiquement une variante de fabrication du siliciure conformément au procédé de l'invention.

La description qui suit se rapporte à la fabrication d'un circuit CMOS comportant un transistor à canal n et un transistor à canal p à double jonction formés dans un substrat en silicium monocristallin de type p, le transistor à canal p étant connecté à un condensateur. Mais, bien entendu, comme on l'a dit précédemment, l'invention s'applique aussi à des circuits nMOS ou pMOS formés dans un substrat en silicium de type n. En outre, le condensateur peut être connecté à un transistor à canal n.

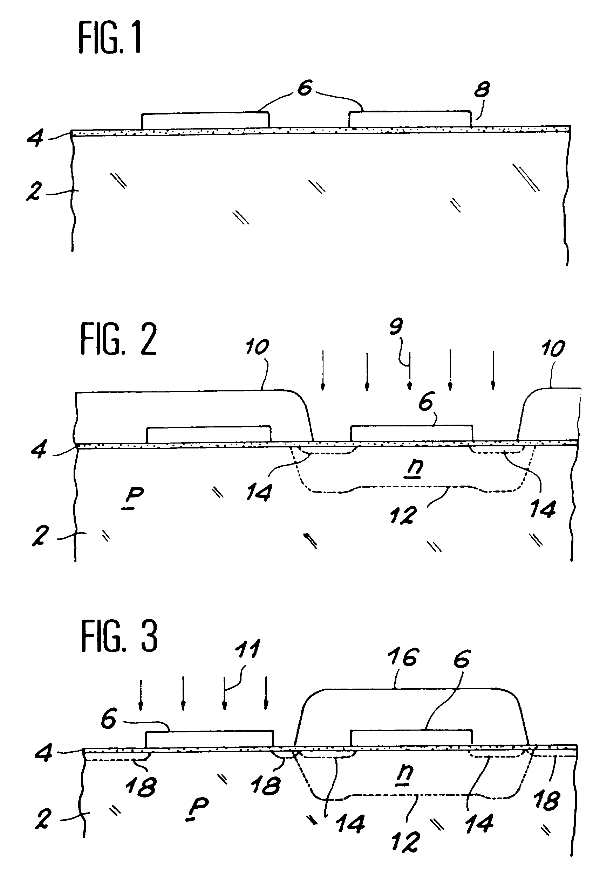

Les étapes suivantes du procédé, représentées sur la figure 1, concernent la définition des emplacements et dimensions des zones actives.

De façon connue, on forme tout d'abord, sur un substrat en silicium monocristallin 2 de type p, un oxyde mince 4 d'environ 25nm par oxydation thermique à 950°C de substrat 2 en atmosphère d'oxygène sec pendant 38min puis on forme un masque 6 de nitrure de silicium définissant l'emplacement et les dimensions des transistors ainsi que celles des isolations latérales ou oxyde de champ à réaliser. Ce masque 6 comporte des ouvertures 8 en regard des zones d'isolation électrique à former.

Ce masque 6 est formé par un dépôt chimique en phase vapeur basse pression (LPCVD) de nitrure de silicium à partir de SiH₂Cl₂+NH₃ sur 90 nanomètres d'épaisseur environ pendant 25min, suivi d'un recuit à 1000°C pendant 30min sous azote, puis réalisation d'une gravure plasma ionique réactive avec SF₆+O₂ à travers un photomasque de résine positive (non représenté), masquant les parties de Si₃N₄ à conserver.

Les étapes suivantes, représentées sur la figure 2, concernent la réalisation d'un caisson de type n.

On forme alors un photomasque 10 en résine définissant l'emplacement et les dimensions du caisson 12 de type n dans lequel sera réalisé le transistor à canal p. Ce caisson 12 est obtenu par implantation d'ions de phosphore à une dose de 3,3.10¹ atomes/cm et une énergie de 180 keV.

Une implantation additionnelle d'ions arsenic à une dose de 7.10¹¹ atomes/cm et une énergie de 50 keV crée des zones d'anti-perçage 14 de part et d'autre du nitrute de silicium 6 masquant la région du transistor à canal p à réaliser.

Les flèches 9 symbolisent ces deux implantations.

Après retrait de la résine 10 par plasma d'oxygène, on effectue un recuit de la structure à 1200°C sous azote pendant 125 minutes.

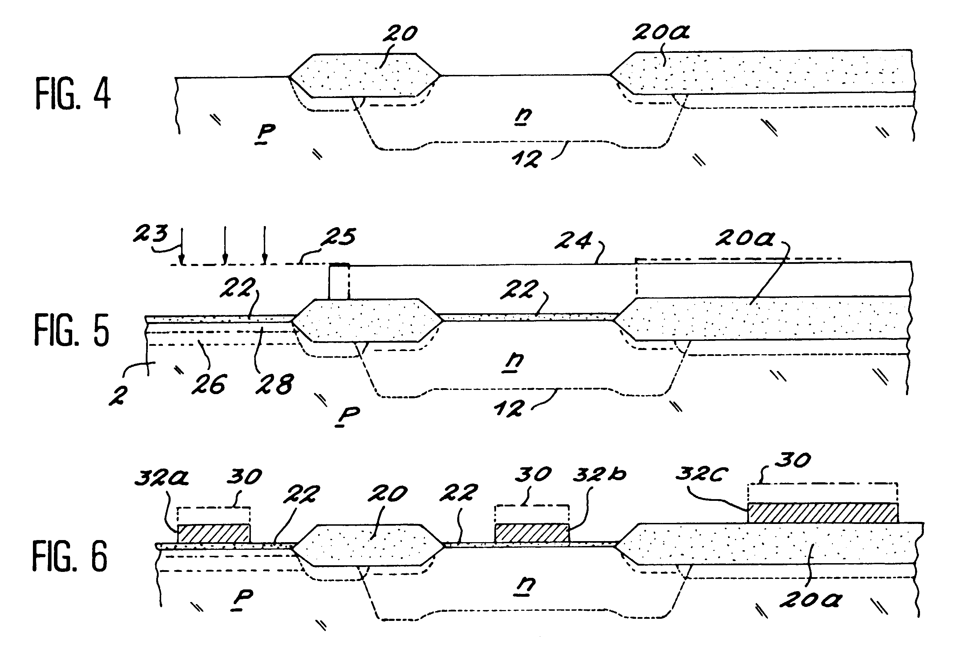

Les étapes suivantes, représentées sur les figures 3 et 4 concernent la réalisation de l'oxyde de champ.

A l'aide d'un photomasque 16 de résine, masquant le caisson n (figure 3), on effectue une implantation ionique 11 de BF₂ à une dose de 2.10¹³ atomes/cm et une énergie de 45 keV, entraînant des zones dopées d'isolement 18 de part et d'autre du nitrure de silicium 6 masquant la région du transistor à canal n à former dans la région de type p du substrat.

Après retrait de la résine 16 avec un plasma d'O₂, comme représenté sur la figure 4, on effectue une oxydation localisée du substrat conduisant ainsi à la formation de l'oxyde de champ ou LOCOS 20, 20a. Cette oxydation est réalisée à 1050°C sous atmosphère d'oxygène, d'hydrogène et de HCl sur une épaisseur de 710nm ± 25nm. La région 20a correspond à l'isolation électrique destinée à supporter le condensateur.

On effectue ensuite l'élimination du masque de nitrure 6 et de l'oxyde formé sur ce dernier lors de l'oxydation thermique du substrat ainsi que celle de l'oxyde 4. A cet effet, on effectue une gravure de l'oxyde à l'aide d'une gravure dite "BOE" pour "Buffered Oxide Etching" (acide fluorhydrique et fluorure d'ammonium) pendant 2min15, puis une gravure du nitrure de silicium par de l'acide orthophosphorique chaud à 145°C pendant 45min, puis une gravure de l'oxyde 4 par BOE pendant 1min30.

On effectue ensuite une réoxydation (non représentée) des zones actives (zones du substrat destinées aux transistors) donnant naissance à une couche d'oxyde sacrificielle ; cette réoxydation est effectuée à 1000°C en atmosphère d'oxygène et d'hydrogène sur 60 nanomètres d'épaisseur environ, puis désoxydation des zones actives par une gravure BOE pendant 4min.

Les étapes suivantes du procédé, représentées sur la figure 5, concernent la formation de l'oxyde de grille et l'ajustement des tensions de seuil des transistors.

On effectue tout d'abord une oxydation des zones actives à 950°C sous atmosphère d'oxygène sec pendant 28min conduisant à l'oxyde de grille 22 de 20nm d'épaisseur puis on réalise un photomasque 24 de résine masquant la région du substrat destinée au transistor à canal p et en particulier le caisson n 12. Ce photomasque 24 sert en outre à masquer l'isolation 20a destinée à supporter le condensateur.

On effectue alors une implantation ionique anti-perçage dans la région destinée au transistor n du circuit intégré avec des ions de bore à une dose de 8.10¹¹ atomes/cm et une énergie de 100 keV. Ce dopage est symbolisé par les tirets 26 dans la région p du substrat, puis une autre implantation ionique de bore à une dose de 2.10¹¹ atomes/cm et une énergie de 25 keV pour l'ajustement du seuil du transistor n. Ce dopage d'ajustement de seuil est symbolisé par les tirets 28 dans la région p du substrat.

Les flèches 23 symbolisent ces deux implantations successives.

Après un retrait de la résine 24 avec un plasma d'oxygène, on effectue une implantation d'ajustement n et p dans tout le circuit intégré consistant à implanter des ions de bore à une dose de 6.10¹¹ atomes/cm et une énergie de 25 keV.

A l'aide d'un photomasque d'ajustement de seuil 25 en résine, représenté en tiret, masquant la région destinée au transistor n ainsi que l'isolation 20a, on effectue une implantation d'ions de bore à une dose de 2.10¹¹ atomes/cm et une énergie de 25 keV dans la région du substrat destinée au transistor à canal p analogique (faible VT) et notamment dans le caisson n. On élimine ensuite ce photomasque 25 avec un plasma d'oxygène.

Cette opération est facultative. Elle n'est faite que sur certains transistors à canal p, pour abaisser la tension de seuil pour certaines applications analogiques.

Les étapes suivantes du procédé concernent le dépôt et la gravure de la première couche conductrice comme représenté sur la figure 6.

A cet effet, on dépose une couche de silicium polycristallin par LPCVD à 600°C de 380nm ± 25nm d'épaisseur sur l'ensemble du circuit intégré puis on effectue un dopage de ce silicium en y implantant des ions de phosphore à une dose de 10¹⁶ atomes/cm et une énergie de 65 keV et on effectue un recuit à 800°C pendant 30min sous atmosphère d'azote.

On effectue alors un photomasque 30 définissant l'emplacement et les dimensions des grilles des transistors ainsi que l'emplacement et les dimensions de la première armature (ou armature inférieure) du condensateur. On effectue alors une gravure plasma du type ionique réactive anisotrope avec du CF₄+Cl₂ ou une chimie de gravure équivalente, l'isolant de grille 22 servant d'arrêt à cette gravure. On obtient ainsi une grille 32a et 32b respectivement des transistors à canal n et p et l'armature 32c inférieure du condensateur situé au-dessus de l'oxyde de champ 20a.

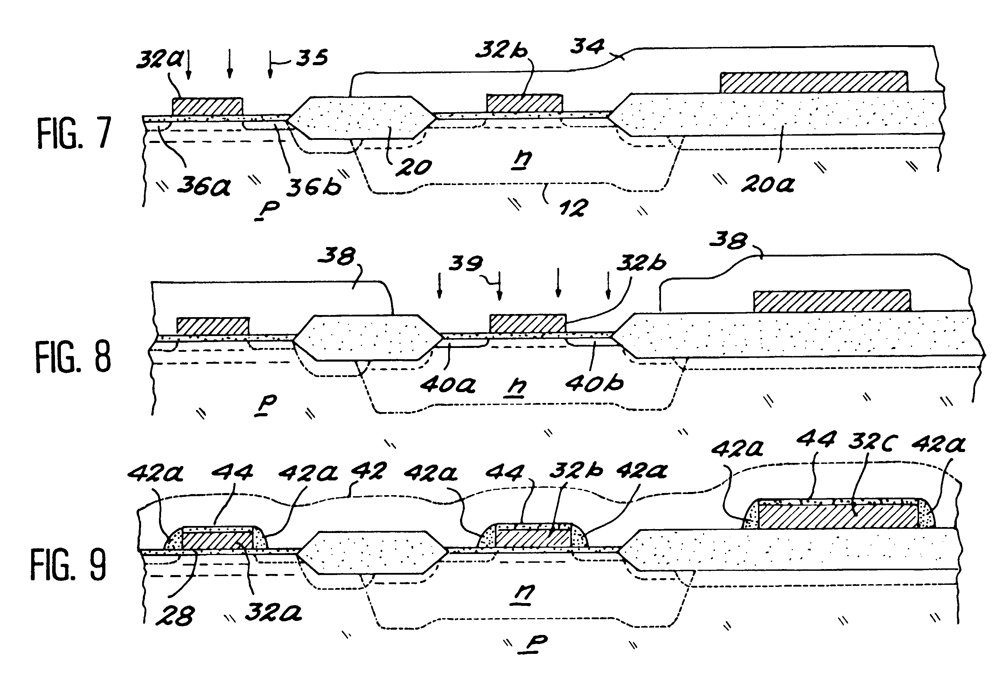

Les étapes suivantes concernent la réalisation des jonctions n et p faiblement dopées, comme représenté sur les figures 7 et 8.

Après élimination du masque de gravure des grilles 30 par plasma d'oxygène, on réalise un nouveau photomasque 34 (figure 7) identique au photomasque 24, masquant la région du circuit intégré destinée au transistor à canal p et en particulier le caisson n 12 ainsi que l'oxyde de champ 20a supportant le condensateur. On effectue alors une implantation 35 d'ions arsenic à une dose de 2.10¹³ atomes/cm et une énergie de 180 keV entraînant ainsi la formation des régions 36a et 36b de type n de part et d'autre de la grille 32a du transistor à canal n, qui constitueront en partie les source et drain de ce transistor ; la grille 32a sert aussi de masque à cette implantation.

Après élimination de la résine 34 par plasma d'oxygène, on effectue un nouveau photomasque 38 de résine, comme représenté sur la figure 8, masquant la région du circuit intégré destinée au transistor à canal n ainsi que l'emplacement destiné au condensateur. A l'aide de ce photomasque 38, on effectue une implantation 39 d'ions bore à une dose de 10¹³ atomes/cm et une énergie de 25 keV pour former deux régions 40a et 40b de type p de part et d'autre de la grille 32b du transistor à canal n. On élimine ensuite le photomasque 38 par plasma d'oxygène.

Les étapes suivantes du procédé concernent la formation d'espaceurs et de l'oxydation des grilles des transistors et l'armature du condensateur, comme représenté sur la figure 9.

On dépose tout d'abord, comme représenté en pointillés, une couche d'oxyde de silicium 42 par dépôt chimique en phase vapeur assisté par un plasma (PECVD) sur une épaisseur de 400nm, cet oxyde étant non dopé. On effectue alors une gravure pleine plaque anisotrope de la couche 42 avec un plasma de CHF₃ et arrêt de gravure sur le silicium polycristallin des grilles 32a et 32b et de l'armature inférieure 32c du condensateur.

On obtient ainsi des espaceurs 42a sur les flancs des grilles 32a et 32b et sur les flancs de l'armature 32c du condensateur. La largeur de ces espaceurs est fonction de l'épaisseur d'oxyde 42 déposée.

On effectue ensuite une oxydation 44 du silicium polycristallin des grilles 32a et 32b et de l'armature 32c du condensateur à 900°C en atmosphère d'oxygène et de vapeur d'eau sur une épaisseur de 45nm.

Les étapes suivantes du procédé concernent la délimitation du diélectrique du condensateur, ainsi que la réalisation des motifs de la ligne d'interconnexion entre le transistor et le condensateur et de l'armature supérieure du condensateur en siliciure, conformément à l'invention.

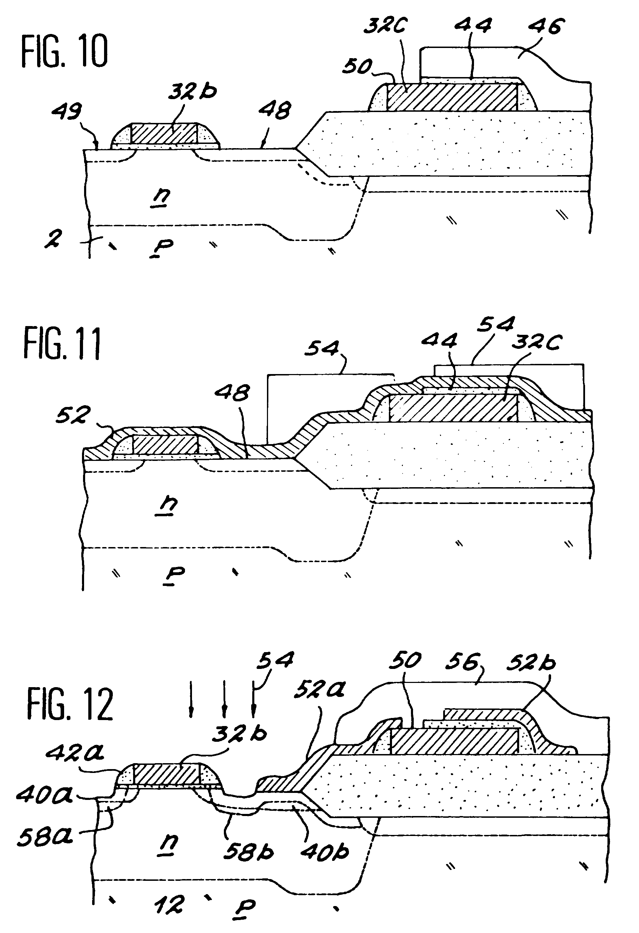

De façon à simplifier les dessins, seuls le transistor et le condensateur à connecter sont représentés sur les figures 10 à 15.

Comme représenté sur la figure 10, on effectue tout d'abord un photomasque de résine 46 fixant les dimensions du diélectrique du condensateur à réaliser. A cet effet, le photomasque 46 ne masque que la région de l'oxyde de condensateur 44 qui supportera la seconde armature en siliciure.

On effectue alors une gravure des oxydes 28 et 44 non masqués. Cette gravure est une gravure ionique réactive utilisant un plasma de CHF₃. Elle permet ainsi la désoxydation des zones à siliciurer telles que la grille 32b (32a), le drain 48 et la source 49 du transistor à canal p ainsi que la zone 50 de l'armature 32c du condensateur, destinée à la prise de contact électrique de la ligne d'interconnexion à réaliser.

On effectue alors comme représenté sur la figure 11, le dépôt d'une couche de silicium polycristallin 52 non dopé sur l'ensemble du circuit intégré d'une épaisseur de 50 à 150nm. Cette couche 52 est déposée par LPCVD à 600°C. On effectue alors un nouveau photomasque 54 de résine fixant les dimensions et l'emplacement de la connexion locale à réaliser entre le drain 48 du transistor à canal p et la première armature 32c du condensateur ainsi que l'emplacement et les dimensions de la seconde armature du condensateur.

On effectue alors une gravure de la couche 52 pour en éliminer les régions non masquées, la détection de fin d'attaque se faisant sur l'oxyde de champ du circuit. Cette gravure doit être suffisamment isotrope pour ne pas former de résidus trop importants en pied de marche. Elle doit être sélective pour ne pas trop creuser le silicium dans les régions de source et drain. A cet effet, on utilise une gravure plasma avec du SF₆ comme agent d'attaque et une sélectivité de 4 environ.

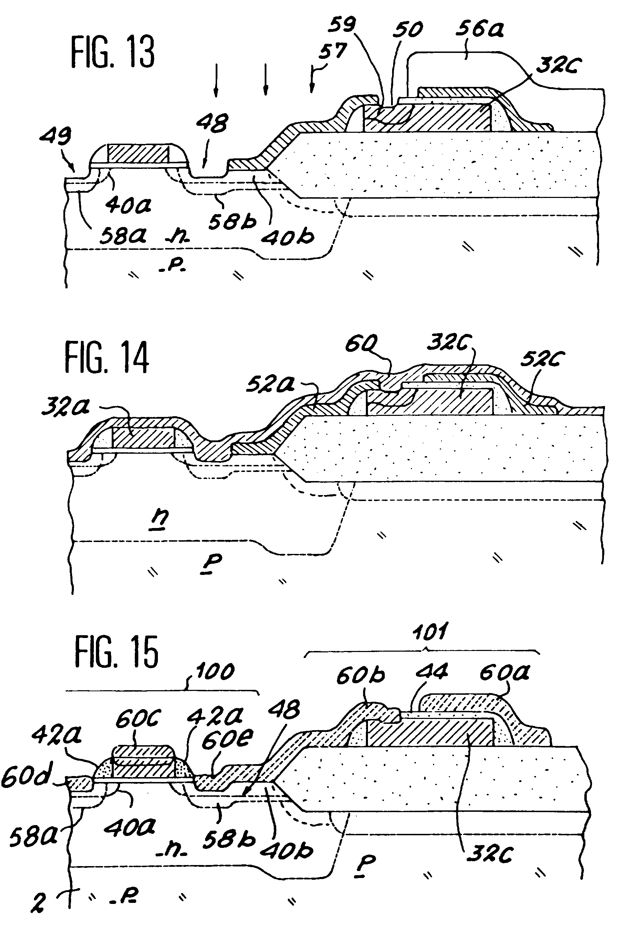

La structure obtenue après cette gravure est représentée sur la figure 12. Les références 52a et 52b indiquent respectivement les motifs de la ligne d'interconnexion et de la seconde armature à réaliser.

Les étapes suivantes concernent la fabrication des sources et drains.

Après élimination du photomasque 54 avec un plasma d'oxygène, on réalise un nouveau photomasque 56 de résine masquant la région du substrat destinée au transistor à canal n ainsi que l'emplacement du condensateur à réaliser.

A l'aide de ce photomasque 56, on effectue alors une implantation 57 de source et drain forte dose dans la région du substrat destinée au transistor à canal p et donc dans le caisson n 12 pour former deux régions implantées 58a et 58b constituant ainsi les source 49 et drain 48 à double jonction du transistor p. Cette implantation 57 est réalisée en utilisant les espaceurs isolants 42a et la grille 32b comme masque à l'implantation. Elle est effectuée avec des ions arsenic à une dose de 10¹⁵ à 10¹⁶ atomes/cm et une énergie de 100 à 180 keV.

Le masque 56 d'implantation de la figure 12 recouvre toute la région destinée au condensateur ainsi que la zone de contact 50 du condensateur. Il est aussi possible de réaliser un masque de photolithogravure 56a ne masquant que la zone du condensateur destinée à la seconde armature et bien entendu, la région du substrat destinée au transistor à canal n. Dans ces conditions, l'implantation d'arsenic 57 introduit un dopage local 59 dans la zone de contact 50 de l'armature 32c du condensateur. Cette zone de dopage 59 permet d'obtenir un excellent contact sur l'armature.

On élimine ensuite le photomasque 56 avec un plasma d'oxygène.

Le Si poly de la LIL peut recevoir, au choix du concepteur, l'implantation As, l'implantation bore ou aucune implantation. On choisira de préférence l'implantation de même type que la zone D ou S où la LIL est connectée. Les régions implantées N⁺ seront séparées des régions P⁺ par une région non implantée, ainsi que les régions qui serviront à la réalisation de résistances de hautes valeurs.

Parallèlement à l'implantation d'arsenic, on effectue une implantation ionique de BF₂ à une dose de 10¹⁵ à 10¹⁶ atomes/cm et une énergie de 180 keV dans la région du circuit intégré destinée au transistor à canal p en utilisant un photomasque (non représenté) identique au masque 34 masquant à la fois la région du transistor à canal n et celle du condensateur.

Cette implantation de source et drain forte dose de type n ou p traverse le silicium polycristallin 52a recouvrant en partie ces zones actives.

On effectue après retrait du photomasque du côté n un recuit d'activation des régions de source et drain entre 950 et 1100°C pendant 5 à 60 secondes.

Les étapes suivantes du procédé consistent à former les shunts de grille, de source et de drain, ainsi que la ligne d'interconnexion locale et la seconde armature du condensateur en siliciure.

L'étape suivante consiste, comme représenté sur la figure 14, à déposer sur l'ensemble du circuit intégré une couche de titane 60 par pulvérisation sur une épaisseur de 80nm. On effectue ensuite un recuit rapide à 700°C en atmosphère d'azote pendant 50 secondes de façon que le titane réagisse avec le silicium polycristallin 52a, 52b, 32c et 32a ainsi que le silicium monocristallin dans les régions des source et drain du transistor pour former du TiSi₂.

A la surface du titane se forme une couche de TiN par réaction du titane avec l'azote. Cette couche a pour rôle de limiter l'extension latérale du TiSi₂ sur l'oxyde 44 du condensateur et sur les espaceurs 42a permettant ainsi un bon isolement électrique entre la grille des transistors et leurs régions de source et de drain. Cet isolement est de l'ordre de 0,3 micromètre, ce qui correspond à la largeur des espaceurs.

On effectue ensuite un retrait sélectif du titane n'ayant pas réagi avec le silicium et du TiN dans un bain d'ammoniaque et d'eau oxygénée à 50% en volume pendant 30min, puis un recuit du siliciure à 900°C pendant 20 secondes.

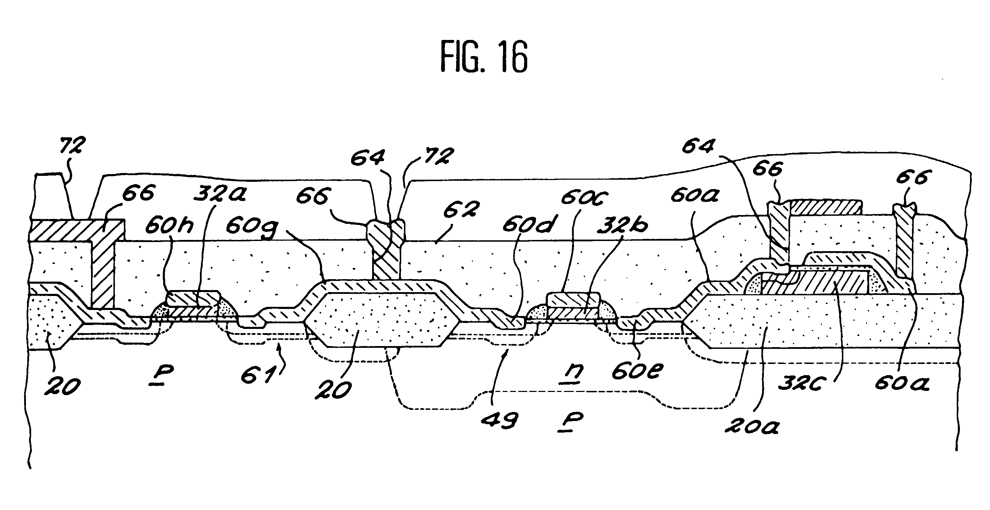

Conformément à l'invention, on a ainsi réalisé, comme représenté sur la figure 15, la seconde électrode 60a du condensateur 101, la ligne d'interconnexion 60b entre le drain 48 du transistor 100 et l'armature 32c du condensateur, le shunt 60c de la grille 32b, le shunt 60d de la source 49 et le shunt 60e du drain 48.

De la même façon que décrit ci-dessus en référence aux figures 11 à 15, on peut réaliser une ligne d'interconnexion locale 60g entre la source 49 du transistor à canal p et le drain 61 du transistor à canal n ainsi que le shunt 60h de la grille 32a du transistor à canal n comme représenté sur la figure 16.

Les étapes suivantes concernent le dépôt du premier isolant de nivellement et de l'ouverture de trous de contact dans cet isolant.

A cet effet, on dépose sur l'ensemble du circuit intégré une couche d'oxyde de silicium 62 par PECVD à partir de tétra-éthyloxysilane (TEOS) à 480°C, constitué d'une alternance de couches non dopées et de couches dopées au phosphore à 3,5% sur une épaisseur de 500nm dont 400nm pour l'oxyde dopé. Ce dépôt est suivi de gravures anisotropes partielles évitant ainsi l'opération de fluage de l'oxyde effectuée classiquement à haute température qui serait néfaste à l'intégrité du TiSi₂. On obtient ainsi une couche diélectrique qui nivelle partiellement la surface du circuit intégré.

Les étapes suivantes sont identiques à celles de l'art antérieur.

Dans cette couche 62, on effectue des trous de contact 64 par gravure plasma ionique réactive avec du CHF₃, après avoir réalisé un photomasque (non représenté) sur l'ensemble du circuit définissant l'emplacement de ces trous de contact ainsi que leurs dimensions. On dépose ensuite une couche de métal et en particulier de tungstène de 500nm d'épaisseur par pulvérisation cathodique ou mieux par CVD. Le dépôt de tungstène par CVD assure le remplissage total des trous de contact de largeur inférieure au micromètre.

A l'aide d'un photomasque (non représenté), on effectue une gravure anisotrope ionique réactive de la couche métallique réalisant ainsi les prises de contact 66 des régions de source et drain et sur l'armature 60a du condensateur.

Le procédé de l'invention permet de supprimer les prises de contact sur les zones de source et drain et de réaliser ces dernières sur l'oxyde de champ 20 ou 20a augmentant ainsi la densité d'intégration des circuits et facilitant la réalisation des trous de contact 64 dans le diélectrique 62. De plus, ce procédé permet une continuité des lignes d'interconnexions 60b ou 60g en TiSi₂ avec le silicium monocristallin dans les régions de source et drain du fait de l'implantation forte dose de ces sources à travers la couche de silicium polycristallin gravée, utilisée pour la réalisation du siliciure.

L'étape suivante du procédé consiste à déposer une nouvelle couche d'oxyde silicium par PECVD non dopé de 800nm d'épaisseur sur l'ensemble du circuit, référencée 70, puis à réaliser dans cette couche d'oxyde 70 des vias 72 par gravure plasma avec CHF₃ en utilisant un photomasque approprié et enfin, réalisation de la deuxième ligne d'interconnexion en métal du circuit intégré de façon connue au-dessus des vias.

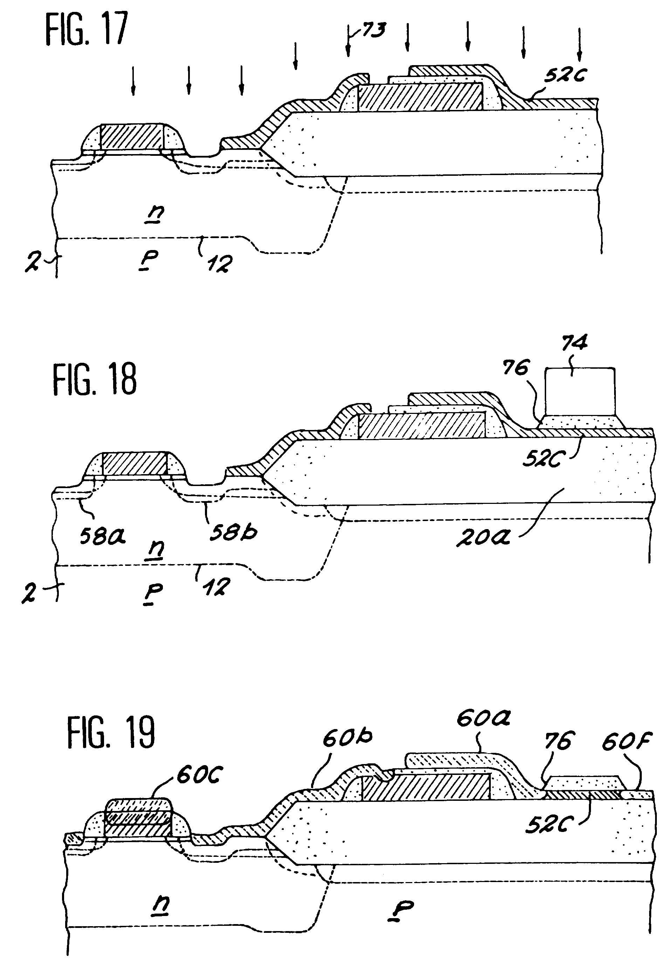

Le procédé conforme à l'invention s'applique aussi à la réalisation de circuits intégrés analogiques-logiques comportant des résistances haute valeur. Les modifications à apporter au procédé décrit ci-dessus sont représentées sur les figures 17 à 19.

Conformément à l'invention, la réalisation des résistances haute valeur intervient lors de la réalisation de la seconde armature du condensateur, après dépôt de la couche de silicium polycristallin 52 (figure 11) et gravure de celle-ci à l'aide d'un photomasque approprié tel que 54 masquant en outre la zone 52c de la couche de silicium destinée à réaliser une résistance haute valeur.

Après la gravure isotrope de la couche de silicium 52, on effectue, comme représenté sur la figure 17, une implantation 73 d'ions arsenic à une énergie de 40 keV et une dose de 1 à 5.10¹⁴ atomes/cm selon la valeur de la résistance souhaitée (de 400 ohms à 2 kohms/carré). Cette implantation 73 est réalisée dans tout le circuit intégré.

Sur l'ensemble de la structure, on dépose ensuite un oxyde de silicium mince non dopé à partir de TEOS, de 40 à 80nm d'épaisseur.

Après réalisation d'un photomasque en résine 74 destiné à masquer la partie de la couche de silicium 52c dans laquelle on réalise la résistance haute valeur, on effectue une gravure ionique réactive de l'oxyde avec un plasma. On obtient ainsi une vignette d'oxyde référencée 76 qui protège localement la partie 52c en silicium, qui ne sera pas siliciurée au cours des étapes ultérieures.

Après la réalisation de cette vignette d'oxyde 76 et l'élimination du photomasque 74, on forme les régions de source et drain 58a et 58b, puis on effectue le dépôt de titane en vue de former le TiSi₂ par recuit sous azote.

Après formation du siliciure, on obtient la structure représentée sur la figure 19.

Les extrémités de la résistance haute valeur 52c sont siliciurées et connectées, soit directement par des lignes d'interconnexions locales telles que 60f aux grilles, drains, sources ou condensateurs du circuit, soit par un contact au niveau de la première métallisation (66, figure 16). Sur la figure 19, la résistance 52c a l'une de ses bornes connectée directement à l'armature 60a du condensateur.

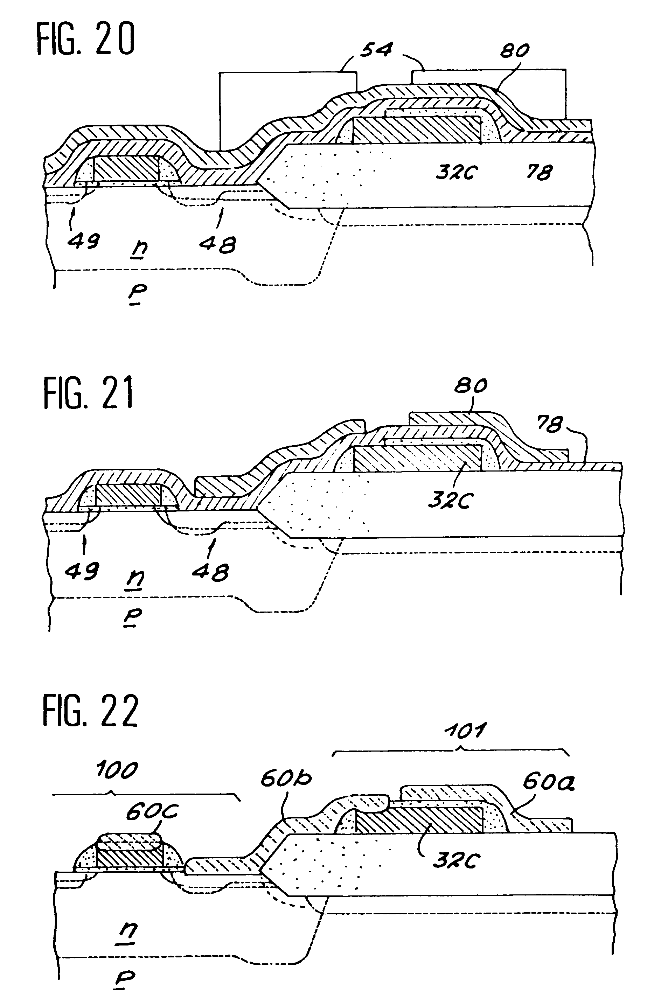

Sur les figures 20 à 22 on a représenté une variante de réalisation du siliciure conformément à l'invention. Ces modifications apparaissent juste après les étapes décrites en référence à la figure 10.

Dans cette variante, on dépose sur l'ensemble de la structure une couche de titane 78 par pulvérisation de 80nm d'épaisseur, puis on dépose, par pulvérisation, une couche de silicium amorphe 80 sur toute la couche de titane 78. Ces dépôts sont effectués dans le même bâti.

On forme alors le photomasque 54 fixant les dimensions de la ligne d'interconnexion locale entre le drain 48 du transistor et l'armature 32c du condensateur, ainsi que les dimensions de la seconde armature du condensateur.

On effectue alors, comme représenté sur la figure 21, une gravure de la couche de silicium 80 selon une gravure anisotrope ionique réactive avec du SF₆.

Après élimination du photomasque 54 avec un plasma d'oxygène, on effectue un recuit rapide à 700°C sous atmosphère d'azote de façon que le silicium 80 réagisse avec le titane sous-jacent pour former l'armature 60a et la ligne d'interconnexion locale en TiSi₂. De plus, du TiSi se forme sur les zones de silicium polycristallin des grilles et du silicium monocristallin des zones actives en contact avec le titane 78.

On élimine ensuite le titane n'ayant pas réagi. La structure finale est celle représentée sur la figure 22.

## Revendications

1. Procédé de fabrication d'un circuit intégré analogique-logique sur un substrat en silicium (2) incluant une première et une seconde régions adjacentes et comportant, dans la première région (p), une isolation électrique (20a) supportant un condensateur (101) et, dans la seconde région (n), un transistor MIS (100) à double jonction (40a-58a, 40b-58b) dont l'une des zones actives (48) est reliée électriquement à une première armature (32c) du condensateur par une ligne d'interconnexion (60b), ce procédé consistant à réaliser, simultanément, en un siliciure d'un métal réfractaire i) ladite ligne d'interconnexion directement sur la zone active et sur la première armature à connecter, ii) la seconde armature (60a) du condensateur et iii) les shunts (60c, 60d, 60e) respectivement de la grille (32b), de la source (49) et du drain (48) du transistor.

2. Procédé selon la revendication 1, caractérisé en ce que le métal réfractaire est le titane.

3. Procédé selon la revendication 1 ou 2, caractérisé en ce qu'il comprend les étapes successives suivantes :
(1) - réalisation de l'isolation électrique (20a) dans la première région du substrat puis d'un isolant de grille du transistor dans la seconde région du substrat,
(2) - réalisation dans une première couche conductrice déposée sur la structure obtenue en (1) de la grille (32b) du transistor (100) et de la première armature (32c) du condensateur (101),
(3) - première implantation d'ions (39) dans la seconde région (n) du substrat de conductivité inverse de celle de la seconde région,
(4) - formation d'espaceurs isolants (42a) sur les flancs de la grille (32b) et sur les flancs de la première armature (32c),
(5) - dépôt d'un matériau diélectrique (44) sur la première armature,
(6) - seconde implantation d'ions (57) dans la seconde région (n) du substrat de conductivité inverse de celle de la seconde région, les espaceurs (42a) servant de masque à cette seconde implantation,
(7) - gravure locale du matériau diélectrique pour former une zone de contact électrique (50) sur la première armature,
(8) - réalisation simultanée de la ligne d'interconnexion (60b), de la seconde armature (60a) du condensateur et des shunts (60c, 60d, 60e) respectivement de la grille, de la source et du drain en siliciure.

4. Procédé selon l'une quelconque des revendications 1 ou 3, caractérisé en ce que l'on forme le siliciure :
a) - en déposant sur l'ensemble du circuit une couche de silicium polycristallin (52),
b) - en gravant cette couche de silicium pour y former les motifs respectivement (52a) de la ligne d'interconnexion et (52b) de la première armature du condensateur,
c) - en déposant une première couche de métal réfractaire (60) sur la structure obtenue en b,
d) - en faisant réagir thermiquement en atmosphère d'azote le métal réfractaire avec le silicium sous-jacent pour former un siliciure à l'emplacement desdits motifs, et
e) - en éliminant le métal réfractaire n'ayant pas réagi avec le silicium.

5. Procédé selon l'une quelconque des revendications 1 ou 3, caractérisé en ce que l'on forme le siliciure :
a) - en déposant sur l'ensemble du circuit une couche de silicium polycristallin (52),
b) - en gravant cette couche de silicium pour y former les motifs respectivement (52a) de la ligne d'interconnexion et (52b) de la première armature du condensateur,
c) - en déposant sélectivement sur le silicium un siliciure d'un métal réfractaire sur la structure obtenue en b,
d) - en faisant réagir thermiquement en atmosphère d'azote le métal réfractaire avec le silicium sous-jacent pour former un siliciure à l'emplacement desdits motifs, et
e) - en éliminant le métal réfractaire n'ayant pas réagi avec le silicium.

6. Procédé selon la revendication 4 ou 5, caractérisé en ce que l'on effectue, en outre, la seconde implantation d'ions dans la zone de contact.

7. Procédé selon la revendication 4, 5 ou 6, caractérisé en ce que la seconde implantation d'ions (57) est effectuée à travers la couche de silicium polycristallin.

8. Procédé de fabrication selon l'une quelconque des revendications 1 à 7, d'un circuit intégré comportant en outre une résistance (52c) sur l'isolation électrique (20a) connectée électriquement au transistor ou au condensateur via une liaison électrique (60f), caractérisé en ce que cette liaison électrique est réalisée en siliciure d'un métal réfractaire en même tant que la ligne d'interconnexion, la seconde armature et les shunts.

9. Procédé selon la revendication 8, caractérisé en ce que l'on forme la résistance (52c) dans la couche de silicium polycristallin lors de sa gravure pour former lesdits motifs et en ce que l'on protège cette résistance par un matériau isolant (76) juste avant de déposer la couche de métal réfractaire.

10. Procédé selon l'une quelconque des revendications 3 à 9, caractérisé en ce que la première couche conductrice est en silicium polycristallin dopé.

## Patentansprüche

1. Verfahren zum Herstellen eines integrierten analogen Logikschaltkreises auf einem Siliziumsubstrat (2), welches eine erste und eine zweite dazu benachbarte Zone enthält und in der ersten Zone (p) eine elektrische Isolierung (20a) aufweist, die einen Kondensator (101) trägt, und in der zweiten Zone (n) einen MIS-Transistor (100) mit doppelter Sperrschicht (40a - 58a, 40b - 58b) aufweist, von dessen aktiven Zonen (48) die eine elektrisch mit einem ersten Belag (32c) des Kondensators über eine Verbindungsleitung (60b) verbunden ist, wobei das Verfahren darin besteht, daß gleichzeitig aus einer Siliziumverbindung mit einem hitzebeständigen Metall i) die Verbindungsleitung direkt auf der aktiven Zone und auf dem ersten anzuschließenden Belag, ii) der zweite Belag (60a) des Kondensators und iii) die Anschlüsse (60c, 60d, 60e) des Gates (32b), der Source (49) und des Drains (48) des Transistors gebildet werden.

2. Verfahren nach Anspruch 1,
**dadurch gekennzeichnet**,
daß das hitzebeständige Metall Titan ist.

3. Verfahren nach Anspruch 1 oder 2,
**dadurch gekennzeichnet**,
daß es die aufeinanderfolgenden Schritte aufweist:
(1) Ausbildung der elektrischen Isolierung (20a) in der ersten Zone des Substrats und anschließend einer Gate-Isolierung des Transistors in der zweiten Zone des Substrats,
(2) in einer ersten leitenden Schicht, die auf die durch (1) erhaltene Struktur aufgebracht ist, Ausbilden des Gates (32b) des Transistors (100) und des ersten Belags (32c) des Kondensators (101),
(3) erste Ionenimplantation (39) in der zweiten Zone (n) des Substrats entsprechend einem Leitungstyp, der demjenigen der zweiten Zone entgegengesetzt ist,
(4) Ausbildung von Isolier-Abstandsstücken (42a) an den Flanken des Gates (32b) und an den Flanken des ersten Belags (32c),
(5) Aufbringen eines Dielektrikums (44) auf den ersten Belag,
(6) zweite Ionenimplantation (57) in der zweiten Zone (n) des Substrats entsprechend einem Leitungstyp, welcher demjenigen der zweiten Zone entgegengesetzt ist, wobei die Abstandsstücke (42a) als Maske für diese zweite Implantation dienen,
(7) lokales Ätzen des Dielektrikums, um eine Zone für einen elektrischen Kontakt (70) auf dem ersten Belag zu bilden,
(8) gleichzeitiges Ausbilden der Verbindungsleitung (60b), des zweiten Belags (60a) des Kondensators und der Anschlüsse (60c, 60d, 60e) des Gates, der Source bzw. des Drains aus Silicid.

4. Verfahren nach einem der Ansprüche 1 oder 3,
**dadurch gekennzeichnet**,
daß die Siliziumverbindung folgendermaßen gebildet wird:
a) auf die Schaltungsanordnung wird eine polykristalline Siliziumschicht (52) aufgebracht,
b) diese Siliziumschicht wird geätzt, um die jeweiligen Muster (52a) der Verbindungsleitung und (52b) des ersten Kondensatorbelags dort auszubilden,
c) Aufbringen einer ersten Schicht aus hitzebeständigem Metall (60) auf der bei b) erhaltenen Struktur,
d) das hitzebeständige Metall wird in einer Stickstoffatmosphäre mit dem darunter befindlichen Silizium thermisch zum Reagieren gebracht, um eine Siliziumverbindung an der Stelle der erwähnten Muster zu bilden, und
e) Beseitigen desjenigen hitzebeständigen Metalls, welches nicht mit dem Silizium reagiert hat.

5. Verfahren nach einem der Ansprüche 1 oder 3,
**dadurch gekennzeichnet,**
daß die Siliziumverbindung ausgebildet wird, indem:
a) auf die Schaltungsanordnung eine polykristalline Siliziumschicht (52) aufgebracht wird,
b) diese Siliziumschicht geätzt wird, um dort die jeweiligen Muster (52a) der Verbindungsleitung und (52b) des ersten Kondensatorbelags auszubilden,
c) auf dem Silizium wird selektiv eine Siliziumverbindung mit einem hitzebeständigen Metall auf der bei b) erhaltenen Struktur aufgebracht,
d) in einer Stickstoffatmosphäre wird das hitzebeständige Metall thermisch mit dem darunter liegenden Silizium zum Reagieren gebracht, um an der Stelle der erwähnten Muster eine Siliziumverbindung zu bilden, und
e) das hitzebeständige Metall, welches nicht mit dem Silizium reagiert hat, wird entfernt.

6. Verfahren nach Anspruch 4 oder 5,
**dadurch gekennzeichnet**,
daß man außerdem die zweite Ionenimplantation in der Kontaktzone vornimmt.

7. Verfahren nach Anspruch 4, 5 oder 6,
**dadurch gekennzeichnet**,
daß man die zweite Ionenimplantation (57) quer zu der polykristallinen Siliziumschicht ausführt.

8. Verfahren zum Herstellen nach einem der Ansprüche 1 bis 7 einer integrierten Schaltung, die außerdem auf der elektrischen Isolierung (20a) einen Widerstand (52c) aufweist, der elektrisch mit dem Transistor oder dem Kondensator über eine elektrische Verbindung (60f) verbunden ist,
**dadurch gekennzeichnet**,
daß diese elektrische Verbindung durch eine Siliziumverbindung mit einem hitzebeständigen Metall gleichermaßen wie die Verbindungsleitung, der zweite Belag und die Anschlüsse ausgeführt wird.

9. Verfahren nach Anspruch 8,
**dadurch gekennzeichnet**,
daß man den Widerstand (52c) in der polykristallinen Siliziumschicht nach dem Ätzen zur Ausbildung der Muster bildet, und daß man diesen Widerstand unmittelbar vor dem Aufbringen der Schicht aus hitzebeständigem Metall mit einem Isolierstoff (76) schützt.

10. Verfahren nach einem der Ansprüche 3 bis 9,
**dadurch gekennzeichnet**,
daß die erste leitende Schicht aus dotiertem polykristallinem Silizium besteht.

## Claims

1. Method to produce an analog/logic integrated circuit on a silicon substrate (2) and including one first and one second adjacent region and comprising, in the first region (p), an electric insulator (20a) and, supporting a capacitor (101) in the second region (n), an MIS double junction point transistor (100) a double junction (40a-58a, 40b-58b), one of the active zones (48) being electrically connected to a first armature (32c) of the capacitor by an interconnection line (60b), this method consisting of simultaneously producing in a silicide of a refractory metal i) said interconnection line directly on the active zone and the first armature to be connected, ii) the second armature (60b) of the capacitor, and iii) the shunts (60c, 60d, 60e) of the grid (32b), the source (49) and the drain (48) respectively of the transistor.

2. Method according to claim 1, characterized in that the refractory metal is titanium.

3. Method according to claim 1 or 2, characterized in that it includes the following successive stages:
(1) - producing an electric insulator (20a) in the first region of the substrate and then a grid nonconductor of the transistor in the second region of the substrate,
(2) - producing in a first conductive film deposited on the structure obtained at (1) from the grid (32b) of the transistor (100) and the first armature (32c) of the capacitor (101),
(3) - a first implantation of ions (39) in the second region (n) of the substrate with conductivity opposite that of the second region,
(4) - formation of insulating spacers (42a) on the flanks of the grid (32b) and on the flanks of the first armature (32c),
(5) - depositing of a dielectric material (44) on the first armature,
(6) - second implantation of ions (57) in the second region (n) of the substrate with conductivity opposite that of the second region, the spacers (42a) being used to mask this second implantation,
(7) - local etching of the dielectric material so as to form an electric contact zone (50) on the first armature,
(8) - simultaneous production of the interconnection line (60b), the second armature (60a) of the capacitor and the shunts (60c, 60d, 60e) of respectively the grid, the source and the silicide drain.

4. Method according to any one of the claims 1 to 3, characterized in that the silicide is formed:
a) - by depositing on the unit of the circuit a film of polycrystalline silicon (52),
b) - by etching this silicon film so as to form there respectively the patterns (52a) of the interconnection line and (52b) of the first armature of the capacitor,
c) - by depositing a first film (60) of refractory metal on the structure obtained at b,
d) - by making in an atmosphere of nitrogen the refractory metal thermically react with the subjacent silicon so as to form a silicide at the location of said patterns, and
e) - by eliminating that portion of the refractory metal which has not reacted with the silicon.

5. Method according to any one of the claims 1 or 3, characterized in that the silicide is formed:
a) - by depositing on the unit of the circuit a film (52) of polycrystalline silicon,
b) - by etching this silicon film so as to form there respectively the patterns (52a) of the interconnection line and (52b) of the first armature of the capacitor,
c) - by selectively depositing on the silicon a silicide of a refractory metal on the structure obtained at b,
d) - by making in a nitrogen atmosphere the refractory metal thermically react with the subjacent silicon so as to form a silicide at the location of said patterns, and
e) - by eliminating that portion of the refractory metal which has not reacted with the silicon.

6. Method according to claim 4 or 5, characterized in that in addition, the second implantation of ions is carried out in the contact zone.

7. Method according to claim 4, 5 or 6, characterized in that the second implantation of ions (57) is effected through the polycrystalline silicon film.

8. Production method according to any one of the claims 1 to 7 of an integrated circuit further comprising a resistor (52c) on the electric insulator (20a) electrically connected to the transistor and the capacitor via an electric link (60f), characterized in that this electric link is made of a silicide of a refractory metal as in the interconnection line, the second armature and the shunts.

9. Method according to claim 8, characterized in that the resistor (52c) is formed in the polycrystalline silicon film at the time the latter is etched so as to form said patterns and in that this resistor is protected by an insulating material (76) before depositing the refractory metal film.

10. Method according to any one of the claims 3 to 9, characterized in that the first conductive film is of doped polycrystalline silicon.
